(19) Europäisches Patentamt
European Patent Office
Office européen des brevets

(11) **EP 3 861 565 B1**

(12) **EUROPÄISCHE PATENTSCHRIFT**

(45) Veröffentlichungstag und Bekanntmachung des Hinweises auf die Patenterteilung:
**13.08.2025  Patentblatt 2025/33**

(21) Anmeldenummer: **19782549.0**

(22) Anmeldetag: **30.09.2019**

(51) Internationale Patentklassifikation (IPC):
**H01J 37/317** (2006.01)   **H01J 37/147** (2006.01)
**H01J 37/153** (2006.01)   **H01J 37/28** (2006.01)

(52) Gemeinsame Patentklassifikation (CPC):
**H01J 37/28; H01J 37/1475; H01J 37/1477; H01J 37/153;** H01J 2237/0453

(86) Internationale Anmeldenummer:
**PCT/EP2019/076472**

(87) Internationale Veröffentlichungsnummer:
**WO 2020/070074 (09.04.2020 Gazette 2020/15)**

(54) **VERFAHREN ZUM BETREIBEN EINES VIELSTRAHL-TEILCHENSTRAHLSYSTEMS**

METHOD FOR OPERATING A MULTI-BEAM PARTICLE BEAM SYSTEM

PROCÉDÉ PERMETTANT DE FAIRE FONCTIONNER UN SYSTÈME DE FAISCEAUX DE PARTICULES À PLUSIEURS FAISCEAUX

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.10.2018  DE 102018124219**

(43) Veröffentlichungstag der Anmeldung:
**11.08.2021  Patentblatt 2021/32**

(73) Patentinhaber: **Carl Zeiss MultiSEM GmbH**
**73447 Oberkochen (DE)**

(72) Erfinder:
• **ZEIDLER, Dirk**
  **73447 Oberkochen (DE)**
• **RIEDESEL, Christof**
  **73433 Aalen (DE)**
• **THOMA, Arne**
  **73430 Aalen (DE)**
• **METALIDIS, Georgo**
  **89551 Königsbronn (DE)**
• **JACOBI, Jörg**
  **89542 Herbrechtingen (DE)**
• **SCHUBERT, Stefan**
  **73447 Oberkochen (DE)**
• **LENKE, Ralf**
  **73466 Lauchheim (DE)**
• **BIHR, Ulrich**
  **73467 Kirchheim/Dirgenheim (DE)**
• **SAROV, Yanko**
  **73431 Aalen (DE)**
• **KURIJ, Georg**
  **73433 Aalen (DE)**

(74) Vertreter: **Diehl & Partner**
**Patent- und Rechtsanwaltskanzlei mbB**
**Erika-Mann-Straße 9**
**80636 München (DE)**

(56) Entgegenhaltungen:
US-A1- 2005 087 701   US-A1- 2010 178 602
US-A1- 2015 069 260   US-A1- 2015 348 738

**Beschreibung**

Die Erfindung betrifft Verfahren zum Betreiben von Vielstrahl-Teilchenstrahlsystemen welche mit einer Vielzahl von Teilchenstrahlen arbeiten.

Aus US 2015/0348738 A1 sind Vielstrahl-Teilchenstrahlsysteme bekannt, welche mehrere Multiaperturplatten verwenden, um einen Teilchenstrahl in eine Vielzahl von Teilchenstrahlen aufzuteilen und um einzelne Teilchenstrahlen der Vielzahl von Teilchenstrahlen durch die Bereitstellung von elektrischen Feldern zu beeinflussen. Beispielsweise werden an von Teilchenstrahlen durchsetzten Öffnungen einer Multiaperturplatte Ringelektroden dazu verwendet, den Teilchenstrahl fokussierende elektrostatische Felder bereitzustellen, und in Umfangsrichtung um die Öffnungen verteilt angeordnete Elektroden werden dazu verwendet, Dipolfelder oder Quadrupolfelder bereitzustellen, um auf den Teilchenstrahl als Strahlablenker bzw. Stigmatoren zu wirken.

Hierzu ist es notwendig, die Vielzahl von Elektroden, welche an den Öffnungen von Multiaperturplatten angebracht sind, um die Teilchenstrahlen zu beeinflussen, mit einstellbaren Spannungen zu versorgen. Da der Wunsch besteht, die Anzahl der Teilchenstrahlen, mit der Vielstrahl-Teilchenstrahlsysteme arbeiten können, zu erhöhen, ist eine sehr große Anzahl von Elektroden an Multiaperturplatten mit Spannungen zu versorgen.

Diese Probleme sind in der US 2015/0069260 A1 als nächstkommender Stand der Technik angesprochen.

Multiaperturplatten, deren Öffnungen mit Elektroden versehen sind, sind komplexe Bauteile, deren Herstellung sehr aufwändig ist. Bei der Herstellung unvermeidbar auftretende Fehler führen dazu, dass eine oder mehrere Elektroden defekt sind, so dass deren Spannung während des Betriebs nicht auf gewünschte Werte einstellbar ist. Ist nur eine Elektrode von den vielen Elektroden einer Multiaperturplatte defekt, führt dies in der Regel dazu, dass die ganze Multiaperturplatte defekt ist und nicht verwendet werden kann. Auch während des Betriebs auftretende Defekte an einzelnen Elektroden einer Multiaperturplatte führen dazu, dass die gesamte Multiaperturplatte ausgetauscht werden muss. Ein als zu hoch empfundener Ausschuss bei der Herstellung von Multiaperturplatten und eine als zu hoch empfundene Ausfallwahrscheinlichkeit während des Betriebs von Multiaperturplatten sind hierbei scheinbar in Kauf zu nehmen. Ein möglicher Ausweg aus dieser Situation liegt in der Entwicklung zuverlässigerer Herstellungsverfahren für Multiaperturplatten, welche ebenfalls aufwändiger sein werden.

Entsprechend ist es eine Aufgabe der vorliegenden Erfindung, Vielstrahl-Teilchenstrahlsysteme und Verfahren zu deren Betrieb vorzuschlagen, welche Anforderungen an die Herstellungsverfahren von Multiaperturplatten im Hinblick auf Defekte an einzelnen Elektroden reduzieren.

Erfindungsgemäß umfasst ein Verfahren zum Betreiben eines Vielstrahl-Teilchenstrahlsystems ein Erzeugen einer Vielzahl von Teilchenstrahlen derart, dass ein jeder Teilchenstrahl der Vielzahl von Teilchenstrahlen ein Multipol-Element durchsetzt, wobei jedes Multipol-Element eine Mehrzahl von Ablenkelementen aufweist, welche in Umfangsrichtung um ein Zentrum des Multipol-Elements verteilt angeordnet sind, und wobei ein jedes der Multipol-Elemente entweder intakt oder defekt ist.

Die Vielzahl von Teilchenstrahlen kann auf vielfältige Weise erzeugt werden. Beispielsweise kann mithilfe eines Teilchenemitters ein Teilchenstrahl erzeugt werden, der auf eine Multiaperturplatte mit einer Vielzahl von Öffnungen gerichtet wird, so dass im Strahlengang hinter der Multiaperturplatte die Vielzahl von Teilchenstrahlen erzeugt wird. Ferner kann eine Vielzahl von Teilchenemittern vorgesehen sein, wobei ein jeder Teilchenemitter einen Teilchenstrahl der Vielzahl von Teilchenstrahlen erzeugt.

Das Teilchenstrahlsystem umfasst typischerweise eine Teilchenoptik, welche die Vielzahl von Teilchenstrahlen auf ein Objekt richtet und dort fokussiert. Die Teilchenoptik muss nicht fehlerfrei sein und kann mit Aberrationen behaftet sein. Eine der Aberrationen ist beispielsweise ein Astigmatismus, dessen Wirkung auf einen gegebenen Teilchenstrahl der Vielzahl von Teilchenstrahlen, welche ein Strahlenbündel bilden, von der Position des Teilchenstrahls innerhalb des Strahlenbündels abhängt.

Um die Wirkung von Aberrationen auf die einzelnen Teilchenstrahlen wenigstens teilweise zu kompensieren, sind die Multipol-Elemente vorgesehen, wobei ein jedes der Multipol-Elemente von einem der Teilchenstrahlen durchsetzt wird. Die Ablenkelemente des Multipol-Elements, welche in Umfangsrichtung um ein Zentrum des Multipol-Elements verteilt angeordnet sind, werden während des Betriebs erregt, um Felder zu erzeugen, welche den das Multipol-Element durchsetzenden Teilchenstrahl beeinflussen, indem sie die einzelnen Teilchen des Teilchenstrahls ablenken. Die den Teilchenstrahl beeinflussenden Felder können elektrische Felder und/oder Magnetfelder sein. Entsprechend können die Ablenkelemente Elektroden zur Erzeugung von elektrischen Feldern und Spulen zum Erzeugen von magnetischen Feldern umfassen. Die Erregung der Ablenkelemente kann dann so erfolgen, dass eine Fokussierung jedes der Teilchenstrahlen in einer vorbestimmten Ebene wenigstens einem vorbestimmten Kriterium genügt. Die vorbestimmte Ebene kann beispielsweise die Oberfläche eines Objekts sein, auf das die Teilchenstrahlen gerichtet sind. Das vorbestimmte Kriterium kann beispielsweise fordern, dass der jeweilige Teilchenstrahl in der vorbestimmten Ebene so fokussiert wird, dass der Querschnitt des Teilchenstrahls in dieser Ebene möglichst klein ist oder einen vorbestimmten Wert aufweist, oder dass die Gestalt des Querschnitts eine Abweichung von einer Kreisgestalt aufweist, die kleiner ist als ein Grenzwert. Andere Kriterien sind möglich.

Ein beispielhaftes Multipol-Element weist zwei bezüglich dem Zentrum des Multipol-Elements gegenüberliegend angeordnete Elektroden auf, welche so erregt werden können, dass das Multipol-Element auf den dieses durchsetzenden Teilchenstrahl wie ein Strahlablenker wirkt, der den Teilchenstrahl um einen durch die Erregungen einstellbaren Winkel ablenkt. Ein weiteres beispielhaftes Multipol-Element weist vier in Umfangsrichtung um das Zentrum des Multipol-Elements angeordnete Elektroden auf, welche so erregt werden können, dass das Multipol-Element auf den dieses durchsetzenden Teilchenstrahl wie ein Strahlablenker wirkt, der den Teilchenstrahl um einen durch die Erregungen einstellbaren Winkel ablenkt und in eine durch die Erregungen einstellbare Richtung ablenkt, oder dass das Multipol-Element auf den dieses durchsetzenden Teilchenstrahl wie ein Stigmator wirkt, der den Teilchenstrahl mit einer durch die Erregungen einstellbaren Stärke astigmatisch beeinflusst. Ein weiteres beispielhaftes Multipol-Element weist acht in Umfangsrichtung um das Zentrum des Multipol-Elements angeordnete Elektroden auf, welche so erregt werden können, dass das Multipol-Element auf den dieses durchsetzenden Teilchenstrahl wie ein Stigmator wirkt, der den Teilchenstrahl mit einer durch die Erregungen einstellbaren Stärke und Orientierung astigmatisch beeinflusst.

Um die Ablenkelemente während des Betriebs des Teilchenstrahlsystems zu erregen kann eine Steuerung vorgesehen sein, welche die Ablenkelemente mit den Erregungen versorgt. Die Erregungen können von der Steuerung über elektrische Leitungen zu den einzelnen Ablenkelementen hingeführt werden. Wenn die Ablenkelemente Elektroden sind, sind die elektrischen Leitungen elektrisch leitende Verbindungen, die geeignet sind, eine von der Steuerung bereitgestellte Spannung zu der jeweiligen Elektrode zu leiten. Wenn die Ablenkelemente Spulen sind, sind die Leitungen elektrisch leitfähige Verbindungen, welche in der Lage sind einen zur Erregung der Spule notwendigen Strom zu der Spule zu leiten.

Bei der Herstellung der Multiaperturplatte oder während des Betriebs der Multiaperturplatte können Fehler auftreten, welche dazu führen, dass einzelne Multipol-Elemente nicht intakt sondern defekt sind. Beispielsweise kann ein einzelnes Ablenkelement des Multipol-Elements defekt sein, indem es während des Betriebs nicht wie gewünscht erregbar ist. Beispielsweise kann eine elektrische Leitung, welche zu dem betreffenden Ablenkelement führt, eine Leitungsunterbrechung aufweisen. Beispielsweise kann eine Elektrode, welche das betreffende Ablenkelement bildet, einen Isolationsdefekt aufweisen, so dass diese Elektrode leitend mit der Multiaperturplatte oder mit einer anderen Elektrode verbunden ist und aus diesem Grund eine gewünschte Spannung nicht annehmen kann. Beispielsweise kann eine Spule, welche ein gegebenes Ablenkelement bildet, eine Leitungsunterbrechung oder einen Kurzschluss aufweisen, so dass ein Stromfluss mit einer gewünschten Stärke durch diese Spule nicht möglich ist.

Das Verfahren umfasst ferner ein Bestimmen von Erregungen für die Ablenkelemente der Multipol-Elemente, um die die Multipol-Elemente durchsetzenden Teilchenstrahlen zu beeinflussen, wobei die Erregungen für die Ablenkelemente eines jeden der Multipol-Elemente so bestimmt werden, dass diese den das Multipol-Element durchsetzenden Teilchenstrahl in einer gewünschten Weise beeinflussen.

Das Verfahren umfasst ferner ein Erregen der Ablenkelemente der Multipol-Elemente, welche intakt sind, mit den bestimmten Erregungen.

Um die Ablenkelemente der Multipol-Elemente während des Betriebs so zu erregen, dass sie die einzelnen Teilchenstrahlen vorteilhaft beeinflussen, müssen die hierzu notwendigen Erregungen bestimmt werden. Gemäß beispielhaften Ausführungsformen wird hierzu für jedes der Multipol-Elemente eine Größe bestimmt, welche eine gewünschte Beeinflussung des das Multipol-Element durchsetzenden Teilchenstrahls repräsentiert. Die wenigstens eine Größe kann beispielsweise die Größe eines Strahlastigmatismus umfassen, welchen der Teilchenstrahl beim Auftreffen auf ein Objekt aufweist. Die Erregungen der einzelnen Ablenkelemente eines als Stigmator ausgebildeten Multipol-Elements, das dieser Teilchenstrahl durchsetzt, können dann derart bestimmt werden, dass, wenn die Ablenkelemente des Stigmators mit den bestimmten Erregungen erregt werden, die Wirkung der Ablenkelemente auf den den Stigmator durchsetzenden Teilchenstrahl derart ist, dass die durch die wenigstens eine Größe repräsentierte Beeinflussung des Teilchenstrahls erreicht wird.

Die Erregungen der Ablenkelemente eines jeden Multipol-Elements können hierbei insbesondere so bestimmt werden, dass ein Mittelwert der Erregungen des Multipol-Elements einen Wert aufweist, der für alle Multipol-Elemente gleich ist. Der Mittelwert kann als das arithmetische Mittel der Erregungen der Ablenkelemente des Multipol-Elements errechnet werden. Wenn die Ablenkelemente beispielsweise Elektroden sind, umfasst das Bestimmen der Erregungen ein Bestimmen von elektrischen Spannungen, und das Erregen der Ablenkelemente umfasst ein Anlegen der bestimmten Spannungen an die Elektroden. Der Mittelwert der Erregungen ist dann durch den Mittelwert der an die Elektroden angelegten Spannungen gegeben. Wenn dieser Mittelwert für alle beispielsweise als Stigmatoren betriebenen Multipol-Elemente gleich ist, unterscheiden sich die Wirkungen der einzelnen Multipol-Elemente bzw. Stigmatoren lediglich hinsichtlich ihrer ablenkenden und stigmierende Wirkungen auf die einzelnen Teilchenstrahlen, nicht jedoch hinsichtlich ihrer fokussierenden Wirkungen auf die Teilchenstrahlen.

Die Ablenkelemente der Multipol-Elemente, welche intakt sind, können dann mit den wie vorangehend beschrieben bestimmten Erregungen erregt werden.

Das Verfahren umfasst ferner ein Abwandeln der bestimmten Erregungen für die Ablenkelemente wenigstens eines Multipol-Elements der Multipol-Elemente, welche defekt sind, und ein Erregen der Elektroden des defekten Multipol-Elements mit den abgewandelten Erregungen.

Wenn ein Multipol-Element defekt ist, wird es nicht möglich sein, die Ablenkelemente des defekten Multipol-Elements mit den Erregungen zu erregen, die so bestimmt wurden, wie dies vorangehend beschrieben wurde. Aufgrund des Defekts eines einzelnen Ablenkelements kann es beispielsweise nicht möglich sein, dieses Ablenkelement mit der für dieses Ablenkelement bestimmten Erregung zu erregen. In diesem Fall werden die zuvor bestimmten Erregungen mit dem Ziel abgewandelt, die Ablenkelemente des Multipol-Elements mit den abgewandelten Erregungen tatsächlich erregen zu können und dennoch eine Beeinflussung des das defekte Multipol-Element durchsetzenden Teilchenstrahls zu erreichen, welche das ursprüngliche Ziel der Beeinflussung, wie beispielsweise die Kompensation eines Strahlastigmatismus, wenigstens teilweise erreicht. Das Abwandeln der Erregungen der Ablenkelemente des defekten Multipol-Elements trägt der Tatsache Rechnung, dass beispielsweise die Erregung eines der Ablenkelemente nicht frei einstellbar sondern festgelegt ist.

Gemäß beispielhaften Ausführungsformen umfasst das Abwandeln der bestimmten Erregungen das Bestimmen der abgewandelten Erregungen derart, dass das defekte Ablenkelement so erregt wird, dass dessen Erregung gleich der festgelegten Erregung ist. Beispielsweise kann eine Korrektur-Erregung bestimmt werden, welche zu der bestimmten Erregung des defekten Ablenkelements addiert wird, um die abgewandelte Erregung zu berechnen, wobei die Korrektur-Erregung so groß ist wie die Differenz zwischen der festgelegten Erregung und der bestimmten Erregung.

Gemäß beispielhaften Ausführungsformen umfasst das Abwandeln der bestimmten Erregungen für die Ablenkelemente eines Multipol-Elements ein Addieren von Korrekturerregungen zu den bestimmten Erregungen.

Gemäß weiteren beispielhaften Ausführungsformen können die Korrekturerregungen für alle Ablenkelemente des defekten Multipol-Elements gleich sein.

Gemäß weiteren beispielhaften Ausführungsformen sind die Korrekturerregungen zwar für alle Ablenkelemente eines gegebenen defekten Multipol-Elements gleich, sie können jedoch für verschiedene defekte Multipol-Elemente verschieden sein.

Gemäß beispielhaften Ausführungsformen können die Korrekturerregungen als die Differenz zwischen der festgelegten Erregung des defekten Ablenkelements und der wie vorangehend erläutert bestimmten Erregung des Ablenkelements berechnet werden.

Beispielsweise können die Ablenkelemente des defekten Multipol-Elements mit den abgewandelten Erregungen erregt werden, wenn die abgewandelte Erregung des defekten Ablenkelements mit dessen aufgrund des Defekts festgelegten Erregung übereinstimmt.

Insbesondere ist es auf diese Weise möglich, das beispielsweise als Stigmator betriebene Multipol-Element so zu erregen, dass es eine gewünschte stigmatische oder ablenkende Wirkung auf den das defekte Multipol-Element durchsetzenden Teilchenstrahl nahezu so bereitstellt wie bei einem intakten Stigmator. Hierbei ist es möglich, dass das mit den abgewandelten Erregungen erregte Multipol-Element auf den dieses durchsetzenden Teilchenstrahl eine weitere Wirkung bereitstellt, welche das mit den bestimmten Erregungen erregte intakte Multipol-Element nicht bereitstellen würde. In manchen Situationen beim Einsatz der Multiaperturplatte mit dem defekten Multipol-Element ist es allerdings möglich, dass das Vielstrahl-Teilchenstrahlsystem mit dem defekten Multipol-Element trotz der zusätzlichen Wirkung mit Erfolg betrieben werden kann.

Insbesondere führt das Addieren einer gleichen Korrektur-Erregung zu allen Erregungen eines Multipol-Elements dazu, dass sich im Wesentlichen nur die fokussierende Wirkung des Multipol-Elements auf den Teilchenstrahl, nicht aber dessen ablenkenden oder stigmierenden Wirkungen ändern. Die Erfinder haben ferner festgestellt, dass die hierbei typischerweise auftretende Änderung der Fokussierung in der Praxis häufig vernachlässigbar ist, während die ablenkenden und stigmierenden Wirkungen, welche sich bei vergleichsweise kleinen Änderungen der Erregungen normalerweise stark ändern, im Wesentlichen unverändert bleiben.

Somit ist es möglich, auch Multiaperturplatten, welche Multipol-Elemente mit bestimmten Defekten aufweisen, für das Vielstrahl-Teilchenstrahlsystem einzusetzen, weshalb bestimmte Herstellungsfehler der Multiaperturplatten zu verwendbaren Multiaperturplatten und nicht zu Ausschuss führen. Der Ausschuss bei der Herstellung der Multiaperturplatten kann somit reduziert werden. Falls ein Defekt während des Betriebs des Vielstrahl-Teilchenstrahlsystems auftritt, kann ferner das Erregen der Ablenkelemente der Multipol-Elemente der Multiaperturplatte dahingehend geändert werden, dass den Ablenkelementen eines nun defekten Multipol-Elements die zuvor erläuterten abgewandelten Erregungen zugeführt werden. Somit ist es möglich, dass Vielstrahl-Teilchenstrahlsysteme auch nach einem Auftreten von Defekten an Multipol-Elementen einer Multiaperturplatte weiterbetrieben werden können und die Multiaperturplatte nicht ausgetauscht werden muss.

Gemäß weiteren Ausführungsformen der Erfindung umfasst ein Vielstrahl-Teilchenstrahlsystem mehrere Multiaperturplatten, welche jeweils eine Vielzahl von Öffnungen aufweisen, wobei bei einer ersten Teilmenge der Öffnungen jeder der mehreren Multiaperturplatten wenigstens ein ansteuerbares Ablenkelement vorgesehen ist, und wobei die mehreren Multiaperturplatten im Strahlengang hintereinander angeordnet sind. Eine Vielstrahl-Teilchenquelle ist zur Erzeugung einer Vielzahl von Teilchenstrahlen derart vorgesehen, dass ein jeder Teilchenstrahl die mehreren Multiaperturplatten nacheinander durch deren Öffnungen durchsetzt.

Das wenigstens eine Ablenkelement kann beispielsweise eine Elektrode umfassen, welche mit einer Spannungsquelle verbunden ist, um der Elektrode eine einstellbare Spannung zuzuleiten, um ein elektrisches Feld zu erzeugen oder ein bestehendes elektrisches Feld zu verändern, welches auf die Teilchen des die Öffnung durchsetzenden Teilchenstrahl ablenkend wirkt. Das wenigstens eine Ablenkelement kann ferner beispielsweise eine Spule umfassen, welche mit einer Stromquelle verbunden ist, um der Spule einen einstellbaren Strom zuzuführen, um ein magnetisches Feld zu erzeugen oder ein bestehendes magnetisches Feld zu verändern, welches auf die Teilchen des die Öffnung durchsetzenden Teilchenstrahl ablenkend wirkt.

An der Öffnung kann beispielsweise genau ein Ablenkelement vorgesehen sein, welches die Teilchen des die Öffnung durchsetzenden Teilchenstrahls so ablenken, dass auf diesen eine fokussierende oder defokussierende Wirkung ausgeübt wird. An der Öffnung können ferner beispielsweise zwei Ablenkelemente vorgesehen sein, welche die Teilchen des die Öffnung durchsetzenden Teilchenstrahls so ablenken, dass auf diesen zusätzlich zu einer fokussierenden oder defokussierenden Wirkung eine ablenkende Wirkung ausgeübt wird. An der Öffnung können ferner beispielsweise vier Ablenkelemente vorgesehen sein, welche die Teilchen des die Öffnung durchsetzenden Teilchenstrahls so ablenken, dass auf diesen eine fokussierende oder defokussierende Wirkung und eine ablenkende Wirkung ausgeübt wird, deren Orientierung einstellbar ist. An der Öffnung können ferner beispielsweise acht Ablenkelemente vorgesehen sein, welche die Teilchen des die Öffnung durchsetzenden Teilchenstrahls so ablenken, dass auf diesen eine fokussierende oder defokussierende Wirkung und eine ablenkende oder stigmierende Wirkung ausgeübt wird, deren Orientierungen einstellbar sind.

Gemäß beispielhaften Ausführungsformen sind die ersten Teilmengen der Öffnungen der mehreren Multiaperturplatten derart arrangiert, dass jeder Teilchenstrahl genau eine Öffnung der mehreren Multiaperturplatten durchsetzt, an der das wenigstens eine ansteuerbare Ablenkelement vorgesehen ist.

Die mehreren Multiaperturplatten können insoweit einen gleichen Aufbau aufweisen, als dass die Anzahl und die Anordnung ihrer Öffnungen gleich sind. Hierdurch ist es insbesondere möglich, dass ein jeder Teilchenstrahl der Vielzahl von Teilchenstrahlen eine Öffnung einer ersten Multiaperturplatte der mehren Multiaperturplatten durchsetzt, dann eine Öffnung einer zweiten Multiaperturplatte der mehren Multiaperturplatten durchsetzt und, wenn die Zahl der mehreren Multiaperturplatten größer als zwei ist, entsprechend Öffnungen weiterer Multiaperturplatten durchsetzt. Die mehreren Multiaperturplatten unterscheiden sich dahingehend, dass bei gleicher Anordnung der Öffnungen der mehreren Multiaperturplatten die jeweiligen Anordnungen der Öffnungen verschieden sind, welche ansteuerbare Ablenkelemente aufweisen. Bei jeder der mehreren Multiaperturplatten ist die Anzahl der Öffnungen, welche ansteuerbare Ablenkelemente aufweisen, geringer als die Anzahl der Teilchenstrahlen.

Die mehreren Multiaperturplatten haben gemeinsam auf die Vielzahl der Teilchenstrahlen eine Wirkung, die der Wirkung einer herkömmlichen Multiaperturplatte entspricht, welche an jeder der von einem Teilchenstrahl durchsetzten Öffnungen wenigstens ein Ablenkelement aufweist. Aufgrund der im Vergleich zur herkömmlichen Multiaperturplatte geringeren Zahl an ansteuerbaren Ablenkelementen pro Multiaperturplatte, sind die Anforderungen an die Zuführung von Erregungen zu den Ablenkelementen der Multiaperturplatte geringer. Dies kann die Herstellung der mehreren Multiaperturplatte jeweils vereinfachen, eine größere Zahl von von Teilchenstrahlen durchsetzten Öffnungen ermöglichen und eine größere Dichte der von Teilchenstrahlen durchsetzten Öffnungen ermöglichen.

Gemäß beispielhaften Ausführungsformen ist in wenigstens einer der mehren Multiaperturplatten eine zweite Teilmenge von Öffnungen vorgesehen, welche in der ersten Teilmenge nicht enthalten sind und welche wenigstens ein Ablenkelement aufweisen, wobei allerdings eine Erregung dieses wenigstens einen Ablenkelements festgelegt und nicht unabhängig einstellbar ist. Hierdurch ist es beispielsweise möglich, sämtliche Öffnungen der mehreren Multiaperturplatte, soweit es die Herstellung der Ablenkelemente betrifft, gemäß einem gleichen Herstellungsverfahren herzustellen. Allerdings unterscheiden sich die Öffnungen der ersten und der zweiten Teilmenge dahingehend, dass die Ablenkelemente der Öffnungen der zweiten Teilmenge nicht erregbar sind, indem beispielsweise keine Zuleitungen vorgesehen sind, um den Ablenkelementen der Öffnungen der zweiten Teilmenge Erregungen zuzuführen.

Gemäß beispielhaften Ausführungsformen der Erfindung umfasst ein Verfahren zum Betreiben eines Vielstrahl-Teilchenstrahlsystems, welches eine Multiaperturplatte mit Öffnungen Aufweist, an denen jeweils wenigstens eine Elektrode als Ablenkelement vorgesehen ist, ein Bestimmen wenigstens eines Ablenkelements, welches defekt ist, und ein Zuführen eines Hochspannungspulses an das defekte Ablenkelement, um den Defekt zu heilen.

Multiaperturplatten für Vielstrahl-Teilchenstrahlsysteme sind mikroelektromechanische Systeme (MEMS), welche ein dichtes Netz an Leiterbahnen mit Strukturgrößen im Mikrometerbereich aufweisen. Typischerweise umfasst eine Multiaperturplatte ein Substrat aus dotiertem Silizium, welches ein leitendes Material ist. Auf das Substrat ist eine Schicht aus $SiO_2$ aufgebracht, welche als Isolator wirkt. Die Leiterbahnen sind durch eine Aluminiumschicht gebildet, welche auf die $SiO_2$-Schicht aufgebracht und durch lithographische Verfahren strukturiert wurde. Die Leiterbahnen dienen beispielsweise zum Zuführen von elektrischen Potenzialen oder elektrischen Strömen an die Ablenkelemente, welche an Öffnungen der Multiaperturplatte vorgesehen sind. Um diese Funktion bereitzustellen, sollten zum einen die Leiterbahnen nicht unterbrochen sein und zum anderen die Leiterbahnen keinen Kontakt zu dem elektrisch leitenden Substrat aufweisen.

Es hat sich gezeigt, dass fertig hergestellte Multiaperturplatten gelegentlich Kurzschlüsse zwischen den Leiterbahnen und dem leitenden Substrat aufweisen. Eine Ursache kann darin liegen, dass die isolierende $SiO_2$-Schicht zu dünn ist und deshalb einen endlichen Widerstand aufweist. Ein hierdurch bedingter Stromfluss zwischen der Leiterbahn und dem Substrat kann so groß sein, dass eine Spannungs- oder Stromquelle zum Bereitstellen der den Ablenkelementen zuzuführenden Erregungen überlastet wird. Hierbei kann es sein, dass die isolierende $SiO_2$-Schicht nicht gleichförmig dünn ist, sondern fertigungsbedingt in einigen lokalisierten Bereichen zu dünn ist. Es wird angenommen, dass das Verhalten des elektrischen Widerstands zwischen der Leiterbahn und dem Substrat in diesen Bereichen die Charakteristik eines Schottky-Kontakts aufweist.

Die Erfinder haben herausgefunden, dass das Anlegen von kurzen Hochspannungspulsen an eine defekte Leiterbahn einen Kurzschluss zwischen der Leiterbahn und dem Substrat beheben kann. Die Erfinder vermuten, dass der durch den kurzen Hochspannungspuls verursachte Strom zwischen der Leiterbahn und dem Substrat die Defektstelle erwärmt und die isolierende $SiO_2$-Schicht sich in dem Bereich der Defektstelle vergrößert und wieder ausreichend isolierend wird. Das Anlegen von Spannungen aus einem Bereich zwischen 1 kV und 10 kV während einer Zeitdauer zwischen 0,01 ms und 5,0 ms, insbesondere zwischen 0,1 ms 1,0 ms hat sich hierbei als vorteilhaft herausgestellt.

Gemäß beispielhaften Ausführungsformen der Erfindung umfasst ein Vielstrahl-Teilchenstrahlsystem wenigstens eine Multiaperturplatte, die eine Vielzahl von Öffnungen aufweist, wobei an den Öffnungen der wenigstens einen Multiaperturplatte jeweils wenigstens ein ansteuerbares Ablenkelement vorgesehen ist, und ein Spannungsversorgungssystem, welches dazu konfiguriert ist, den Ablenkelementen der wenigstens einen Multiaperturplatte einstellbare Erregungen über Zuleitungen zuzuführen. Dies bedeutet, dass während des Betriebs des Vielstrahl-Teilchenstrahlsystems jedem Ablenkelement der wenigstens einen Multiaperturplatte eine einstellbare Erregung von dem Spannungsversorgungssystem zugeführt werden kann. Die Öffnungen der Multiaperturplatte sind mehreren Gruppen von Öffnungen zuordenbar, wobei jede in einer Gruppe von Öffnungen enthaltene Öffnung nicht in einer anderen der Gruppen von Öffnungen enthalten ist. Dies bedeutet, dass nicht mehrere der betrachteten Gruppen gemeinsame Öffnungen enthalten, oder dass die Gruppen disjunkt sind. Diese mögliche Einteilung der Öffnungen in Gruppen gilt für eine Mehrzahl der Öffnungen der Multiaperturplatte, nicht aber unbedingt für alle Öffnungen der Multiaperturplatte. Beispielsweise gilt die Einteilung in Gruppen für mehr als die Hälfte der Öffnungen der Multiaperturplatte.

Gemäß beispielhaften Ausführungsformen weisen alle Öffnungen einer jeden gegebenen Gruppe von Öffnungen jeweils wenigstens ein Ablenkelement auf, welches an eine gegebene Zuleitung angeschlossen ist, so dass Ablenkelemente von mehreren Öffnungen der gleichen Gruppe gemeinsam an diese gegebene Zuleitung angeschlossen sind.

Bei dem herkömmlichen Vielstrahl-Teilchenstrahlsystem sind sämtlichen Ablenkelementen sämtlicher Öffnungen einer Multiaperturplatte unabhängig voneinander einstellbare Erregungen zuführbar. Hierdurch ist gewährleistet, dass jeder Teilchenstrahl, der eine Öffnung der Multiaperturplatte durchsetzt, genau so durch die durch die Ablenkelemente bereitgestellten elektrischen und/oder magnetischen Felder beeinflusst werden kann, wie es für diesen Teilchenstrahl gewünscht oder notwendig ist. Die Erfinder haben festgestellt, dass in der Praxis vielen Ablenkelementen gleiche oder ähnliche Erregungen zuzuführen sind, um die Teilchenstrahlen im Hinblick auf die Kompensation von Abbildungsfehlern anderer optischer Elemente im Strahlengang der Teilchenstrahlen zu beeinflussen. Insbesondere haben die Erfinder festgestellt, dass dann, wenn die Öffnungen mehrere Ablenkelemente aufweisen, um beispielsweise den die Öffnung durchsetzenden Teilchenstrahl stigmatisch zu beeinflussen, benachbarte Öffnungen gleiche oder ähnliche Erregungsmuster erhalten, um die die benachbarten Öffnungen durchsetzenden Teilchenstrahlen wie gewünscht zu beeinflussen.

Deshalb sieht die vorangehend erläuterte Ausführungsform vor, für Ablenkelemente verschiedener Öffnungen, die der gleichen Gruppe angehören, gemeinsame Zuleitungen vorzusehen. Damit wird zwar den Ablenkelementen, welche an die gemeinsame Zuleitung angeschlossen sind, die gleiche Erregung zugeführt, so dass die Erregungen dieser Ablenkelemente nicht mehr unabhängig voneinander eingestellt werden können. Dafür kann aber die Anzahl der Zuleitungen, welche zur Zuführung der Erregungen an die Ablenkelemente der Öffnungen der Multiaperturplatte deutlich reduziert werden. Dennoch ist es möglich, die Ablenkelemente nahezu so zu erregen, wie dies idealerweise gewünscht ist, da die Gruppen aus Öffnungen so gewählt werden können, dass wenigstens einigen Ablenkelementen der Öffnungen einer gleichen Gruppe gleiche Erregungen zugeführt werden können.

Gemäß beispielhaften Ausführungsformen haben mehrere Öffnungen einer jeden gegebenen Gruppe jeweils eine Öffnung als nächsten Nachbarn, welche ebenfalls dieser gegebenen Gruppe von Öffnungen angehört. Dies bedeutet, dass in der Ebene der Multiaperturplatte nahe benachbarte Öffnungen einer gemeinsamen Gruppe angehören. Dahinter steht die Überlegung, dass die einander benachbarten Öffnungen der Multiaperturplatte ähnliche Erregungen für Ihre Ablenkelemente benötigen, um die diese Öffnung durchsetzenden Teilchenstrahlen beispielsweise im Hinblick auf eine Kompensation eines Abbildungsfehlers einer von den Teilchenstrahlen durchsetzten Optik zu beeinflussen. Gemäß beispielhaften Ausführungsformen ist eine Anzahl der Öffnungen, welche der gleichen Gruppe von Öffnungen angehören, im arithmetischen Mittel über alle Gruppen von Öffnungen der Multiaperturplatte aus einem Bereich zwischen 2.0 und 3.0.

Gemäß beispielhaften Ausführungsformen weisen die Öffnungen einer jeden gegebenen Gruppe und insbesondere die Öffnungen aller Gruppen von Öffnungen eine gleiche Anzahl von Ablenkelementen, wie beispielsweise acht Ablenkelementen, auf, welche in Umfangsrichtung um die Öffnung verteilt angeordnet sind.

Ausführungsformen der Erfindung werden nachfolgend anhand von Figuren näher erläutert. Hierbei zeigt:

Figur 1    eine schematische Darstellung eines Vielstrahl-Teilchenstrahlsystems;

Figur 2    eine schematische Querschnittsdarstellung einer Anordnung aus mehreren Multiaperturplatten;

Figur 3    eine Draufsicht auf eine erste Multiaperturplatte der Darstellung der Figur 2;

Figur 4    eine Draufsicht auf eine zweite Multiaperturplatte der Figur 2;

Figur 5    eine schematische Draufsicht auf eine Variante der Multiaperturplatten der Figuren 3 und 4;

Figur 6    eine schematische Darstellung eines intakten Multipol-Elements, das mit bestimmten Erregungen erregt wird;

Figur 7    eine schematische Darstellung eines defekten Multipol-Elements, das mit den bestimmten Erregungen der Figur 6 erregt wird;

Figur 8    eine schematische Darstellung des defekten Multipol-Elements der Figur 7, das mit abgewandelten Erregungen erregt wird;

Figur 9    ein Flussdiagramm zur Erläuterung eines Verfahrens zum Betreiben eines Vielstrahl-Teilchenstrahlsystems;

Figur 10   eine schematische Darstellung von zu korrigierenden Strahlastigmatismen für eine Vielzahl von Öffnungen einer Multiaperturplatte;

Figur 11   eine Erläuterung einer elektrischen Schaltung zum Zuführen von Erregungen an Ablenkelemente verschiedener Öffnungen durch gemeinsame Zuleitungen; und

Figur 12   eine der Figur 10 entsprechende schematische Darstellung einer Einteilung von Öffnungen der Multiaperturplatte in Gruppen.

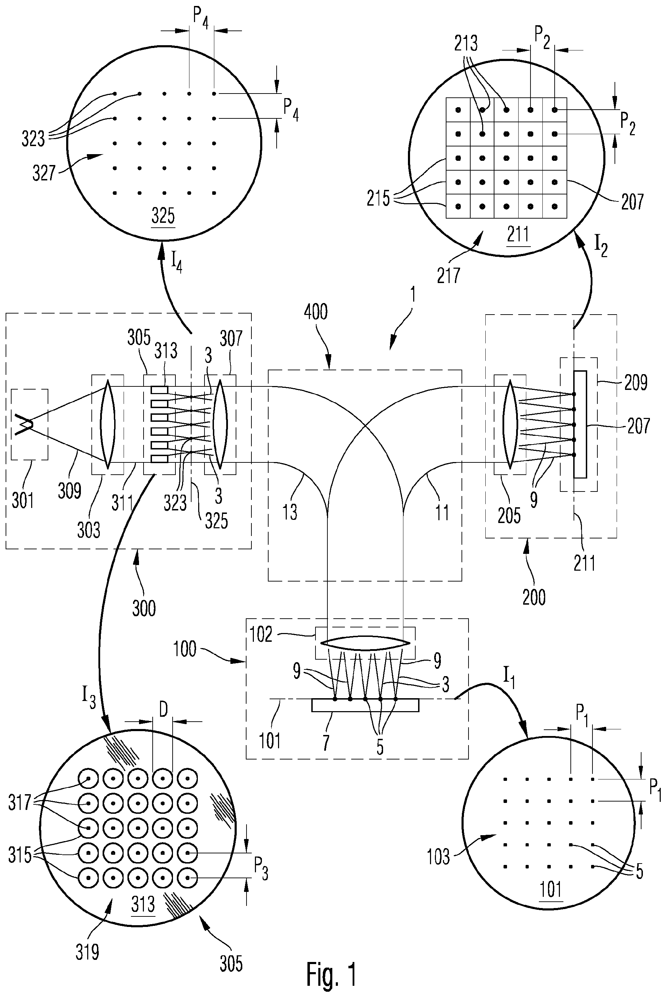

Figur 1 ist eine schematische Darstellung eines Vielstrahl-Teilchenstrahlsystems 1, welches mit einer Vielzahl von Teilchenstrahlen arbeitet. Das Vielstrahl-Teilchenstrahlsystem 1 erzeugt eine Vielzahl von Teilchenstrahlen, welche auf ein zu untersuchendes Objekt treffen, um dort Elektronen zu erzeugen, welche von dem Objekt ausgehen und nachfolgend detektiert werden. Das Vielstrahl-Teilchenstrahlsystem 1 ist vom Rasterelektronenmikroskoptyp ("scanning electron microscope", SEM), welches mehrere primäre Elektronenstrahlen 3 einsetzt, die an Orten 5 auf einer Oberfläche des Objekts 7 auftreffen und dort mehrere Elektronenstrahlflecken bzw. -spots erzeugen. Das zu untersuchende Objekt 7 kann von einer beliebigen Art sein und beispielsweise einen Halbleiter-Wafer, eine biologische Probe und eine Anordnung miniaturisierter Elemente oder dergleichen umfassen. Die Oberfläche des Objekts 7 ist in einer Objektebene 101 einer Objektivlinse 102 eines Objektivlinsensystems 100 angeordnet.

Der vergrößerte Ausschnitt I1 der Figur 1 zeigt eine Draufsicht auf die Objektebene 101 mit einem regelmäßigen rechtwinkligen Feld 103 von Auftrefforten 5, welche in der Ebene 101 gebildet werden. In Figur 1 beträgt die Zahl der Auftrefforte 25, welche ein 5 x 5-Feld 103 bilden. Die Zahl 25 an Auftrefforten ist eine aus Gründen der vereinfachten Darstellung gewählte kleine Zahl. In der Praxis kann die Zahl an Strahlen bzw. Auftrefforten wesentlich größer gewählt werden, wie beispielsweise 20 x 30, 100 x 100 und dergleichen.

In der dargestellten Ausführungsform ist das Feld 103 von Auftrefforten 5 ein im Wesentlichen regelmäßiges rechtwinkliges Feld mit einem konstanten Abstand P1 zwischen benachbarten Auftrefforten. Beispielhafte Werte des Abstands P1 sind 1 Mikrometer, 10 Mikrometer und 40 Mikrometer. Es ist jedoch auch möglich, dass das Feld 103 andere Symmetrien aufweist, wie beispielsweise eine hexagonale Symmetrie.

Ein Durchmesser der in der Objektebene 101 geformten Strahlflecken kann klein sein. Beispielhafte Werte dieses Durchmessers betragen 1 Nanometer, 5 Nanometer, 100 Nanometer und 200 Nanometer. Das Fokussieren der Teilchenstrahlen 3 zur Formung der Strahlflecken 5 erfolgt durch das Objektivlinsensystem 100.

Die auf das Objekt treffenden Teilchen erzeugen Elektronen, welche von der Oberfläche des Objekts 7 ausgehen. Die von der Oberfläche des Objekts 7 ausgehenden Elektronen werden durch die Objektivlinse 102 zu Elektronenstrahlen 9 geformt. Das Inspektionssystem 1 stellt einen Elektronenstrahlengang 11 bereit, um die Vielzahl von Elektronenstrahlen 9 einem Detektionssystem 200 zuzuführen. Das Detektionssystem 200 umfasst eine Elektronenoptik mit einer Projektionslinse 205, um die Elektronenstrahlen 9 auf einen Elektronen-Multi-Detektor 209 zu richten.

Der Ausschnitt I2 in Figur 1 zeigt eine Draufsicht auf eine Ebene 211, in welcher einzelne Detektionsbereiche liegen, auf welche die Elektronenstrahlen 9 an Orten 213 auftreffen. Die Auftrefforte 213 liegen in einem Feld 217 mit einem regelmäßigen Abstand P2 zueinander. Beispielhafte Werte des Abstands P2 sind 10 Mikrometer, 100 Mikrometer und 200 Mikrometer.

Die primären Elektronenstrahlen 3 werden in einer Strahlerzeugungsvorrichtung 300 erzeugt, welche wenigstens eine Elektronenquelle 301, wenigstens eine Kollimationslinse 303, eine Multiaperturplattenanordnung 305 und eine Feldlinse 307 umfasst. Die Elektronenquelle 301 erzeugt einen divergierenden Elektronenstrahl 309, welcher durch die Kollimationslinse 303 kollimiert wird, um einen Strahl 311 zu formen, welcher die Multiaperturplattenanordnung 305 beleuchtet.

Der Ausschnitt I3 in Figur 1 zeigt eine Draufsicht auf die Multiaperturplattenanordnung 305. Die Multiaperturplattenanordnung 305 umfasst eine Multiaperturplatte 313, welche eine Mehrzahl von darin ausgebildeten Öffnungen 315 aufweist. Mittelpunkte 317 der Öffnungen 315 sind in einem Feld 319 angeordnet, welches dem Feld 103 entspricht, welches durch die Strahlflecken 5 in der Objektebene 101 gebildet wird. Ein Abstand P3 der Mittelpunkte 317 der Öffnungen 315 voneinander kann beispielhafte Werte von 5 Mikrometer, 100 Mikrometer und 200 Mikrometer aufweisen. Die Durchmesser D der Öffnungen 315 sind kleiner als der Abstand P3 der Mittelpunkte der Öffnungen. Beispielhafte Werte der Durchmesser D sind 0,2 x P3, 0,4 x P3 und 0,8 x P3.

Elektronen des beleuchtenden Strahls 311 durchsetzen die Öffnungen 315 und bilden Elektronenstrahlen 3. Elektronen des beleuchtenden Strahls 311, welche auf die Platte 313 treffen, werden durch diese abgefangen und tragen nicht zur Bildung der Elektronenstrahlen 3 bei.

Die Multiaperturplattenanordnung 305 kann die Elektronenstrahlen 3 derart fokussieren, dass in einer Ebene 325 Strahlfoki 323 gebildet werden. Ein Durchmesser der Foki 323 kann beispielsweise 10 Nanometer, 100 Nanometer und 1 Mikrometer betragen.

Die Feldlinse 307 und die Objektivlinse 102 stellen eine erste abbildende Teilchenoptik bereit, um die Ebene 325, in der die Foki gebildet werden, auf die Objektebene 101 abzubilden, so dass dort ein Feld 103 von Auftrefforten 5 bzw. Strahlflecken auf der Oberfläche des Objekts 7 gebildet wird.

Die Objektivlinse 102 und die Projektionslinse 205 stellen eine zweite abbildende Teilchenoptik bereit, um die Objektebene 101 auf die Detektionsebene 211 abzubilden. Die Objektivlinse 102 ist somit eine Linse, welche sowohl Teil der ersten als auch der zweiten Teilchenoptik ist, während die Feldlinse 307 nur der ersten Teilchenoptik und die Projektionslinse 205 nur der zweiten Teilchenoptik angehören.

Eine Strahlweiche 400 ist in dem Strahlengang der ersten Teilchenoptik zwischen der Multiaperturplattenanordnung 305 und dem Objektivlinsensystem 100 angeordnet. Die Strahlweiche 400 ist auch Teil der zweiten Teilchenoptik im Strahlengang zwischen dem Objektivlinsensystem 100 und dem Detektionssystem 200.

Weitergehende Information zu solchen Vielstrahl-Teilchenstrahlsystemen und darin eingesetzten Komponenten, wie etwa Teilchenquellen, Multiaperturplatten und Linsen, kann aus den internationalen Anmeldungen WO 2005/024881 A2, WO 2007/028595 A2, WO 2007/028596 A1 und WO 2007/060017 A2 und den deutschen Patentanmeldungen DE 10 2013 016 113 A1, DE 10 2013 014 976 A1 und DE 10 2014 008 083 A1 erhalten werden.

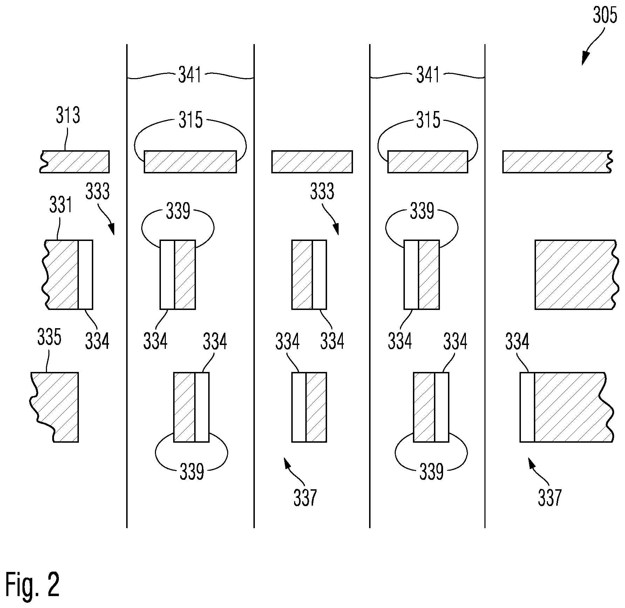

Figur 2 ist eine teilweise Querschnittsansicht der Multiaperturplattenanordnung 305. Diese umfasst die bereits vorangehend erläuterte Multiaperturplatte 313, welche mit ihren Öffnungen 315 zur Formung der Vielzahl von Teilchenstrahlen 3 aus dem beleuchtenden Teilchenstrahl 311 dient. Die Multiaperturplattenanordnung 305 umfasst ferner mehrere weitere Multiaperturplatten. Die Zahl der mehreren weiteren Multiaperturplatten ist in dem erläuterten Beispiel gleich zwei.

Die zwei weiteren Multiaperturplatten sind eine erste Multiaperturplatte 331 mit Stigmatoren 333 und eine zweite Multiaperturplatte 335 mit Stigmatoren 337. Die Multiaperturplatte 331 ist im Strahlengang hinter der Multiaperturplatte 313 angeordnet, und die Multiaperturplatte 335 ist im Strahlengang hinter der Multiaperturplatte 331 angeordnet. Jede der Multiaperturplatten 331 und 335 weist eine Vielzahl von Öffnungen 339 auf, welche von den im Strahlengang hinter der Multiaperturplatte 313 gebildeten Teilchenstrahlen durchsetzt werden. Hierzu sind für jeden Teilchenstrahl ein Zentrum einer Öffnung 315 in der Multiaperturplatte 313, ein Zentrum einer Öffnung 339 in der Multiaperturplatte 331 und ein Zentrum einer Öffnung 339 in der Multiaperturplatte 335 entlang einer Strahlachse 341 angeordnet, so dass die Öffnungen 315 in der Multiaperturplatte 313, die Öffnungen 339 in der Multiaperturplatte 331 und die Öffnungen 339 in der Multiaperturplatte 335 von den Teilchenstrahlen nacheinander durchsetzt werden. In der Figur 2 sind die Strahlachsen 341 orthogonal zu der Multiaperturplatte 331 orientiert, da der die Multiaperturplatte 313 beleuchtende Teilchenstrahl 311 ein paralleler Strahl ist. Es ist jedoch auch möglich, dass der Teilchenstrahl ein konvergenter oder divergenter Strahl ist, so dass die Strahlachsen 341 nicht alle orthogonal zu der Multiaperturplatte 313 orientiert sind.

Die Stigmatoren 333 der ersten Multiaperturplatte 331 und die Stigmatoren 337 der zweiten Multiaperturplatte 335 sind jeweils durch acht Ablenkelemente 334 gebildet, welche in Umfangsrichtung um die Öffnungen 339 verteilt angeordnet sind.

Es sind nicht sämtliche Öffnungen 339 der Multiaperturplatten 331 und 335 mit Stigmatoren 333 bzw. 337 versehen. Entsprechend sind nicht an jeder der Öffnungen 339 der Multiaperturplatten 331 und 335 Ablenkelemente 334 vorgesehen. Vielmehr sind Ablenkelemente 334 an einer ersten Teilmenge der Öffnungen 339 der ersten Multiaperturplatte 331 sowie an einer ersten Teilmenge der Öffnungen 339 der zweiten Multiaperturplatte 335 vorgesehen. Die Teilmengen der Öffnungen 339 der Multiaperturplatten 331 und 335, an denen Ablenkelemente 334 vorgesehen sind, erfüllen folgendes Kriterium: Ein jeder Teilchenstrahl, welcher Öffnungen 339 der ersten Multiaperturplatte 331 und der zweiten Multiaperturplatte 335 durchsetzt, durchsetzt genau eine Öffnung 339, an der Ablenkelemente 334 vorgesehen sind.

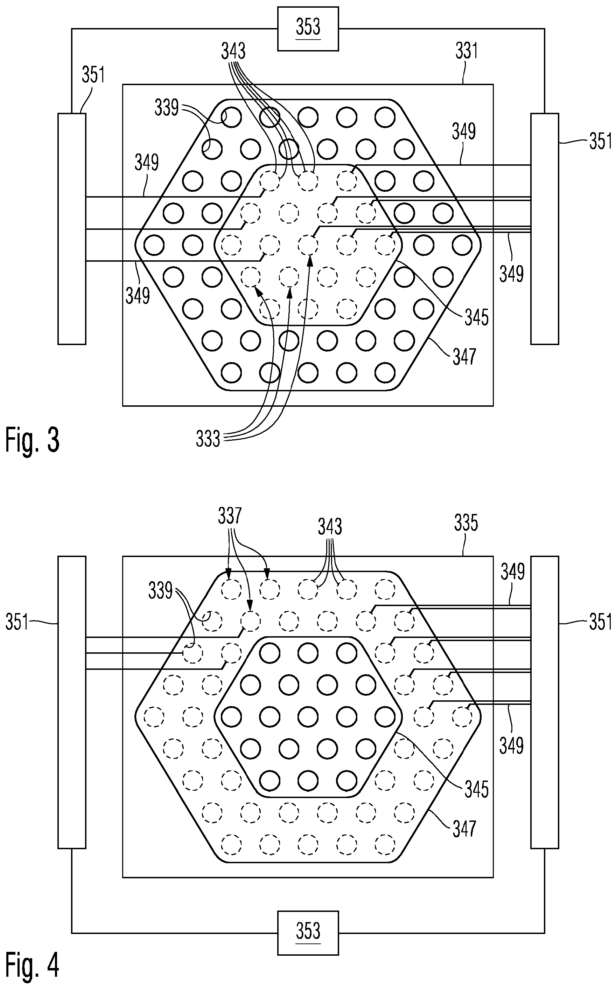

Figur 3 zeigt eine Draufsicht auf die erste Multiaperturplatte 331 mit den Stigmatoren 333, und Figur 4 zeigt eine Draufsicht auf die zweite Multiaperturplatte 335 mit den Stigmatoren 337. Aus der Figur 3 und 4 ist ersichtlich, dass die erste und zweite Multiaperturplatte 331, 335 jeweils 61 Öffnungen 339 aufweisen, welche in einem hexagonalen Muster angeordnet sind. Beide Multiaperturplatten 331 und 335 weisen Öffnungen 339 auf, an welchen in Umfangsrichtung um die jeweilige Öffnung 339 verteilt angeordnete Ablenkelemente 334 vorgesehen sind. Beide Multiaperturplatten 331 und 335 weisen allerdings auch Öffnungen 339 auf, an welchen keine Ablenkelemente 334 angeordnet sind. Eine Linie 345 in Figur 3 umrandet die Teilmenge von Öffnungen 339 der ersten Multiaperturplatte 331, welche mit Ablenkelementen 334 versehen sind. Diese erste Teilmenge von Öffnungen 339 sind 19 Öffnungen 339 der ersten Multiaperturplatte 331, welche in dem hexagonalen Muster der Öffnungen 339 zentral angeordnet sind. Eine Linie 347 in Figur 3 umrandet sämtliche Öffnungen 339 der ersten Multiaperturplatte 331. Die Öffnungen 339, welche außerhalb der Linie 345 und innerhalb der Linie 347 angeordnet sind, bilden eine zweite Teilmenge von Öffnungen 339, an welchen keine Ablenkelemente 334 vorgesehen sind. Die Öffnungen 339 der zweiten Teilmenge von Öffnungen 339 der ersten Multiaperturplatte 331 liegen am Rand der hexagonalen Anordnung von Öffnungen 339.

Die Linien 345 und 347 sind auch in Figur 4 dargestellt. Allerdings sind dort die Öffnungen 339, welche der ersten Teilmenge von Öffnungen 339 angehören, an welchen Ablenkelementen 334 vorgesehen sind, außerhalb der Linie 345 und innerhalb der Linie 347 angeordnet, während die Öffnungen 339 der zweiten Teilmenge mit Öffnungen 339, welche keine Ablenkelemente 334 aufweisen, innerhalb der Linie 345 angeordnet sind. Es ist ersichtlich, dass die Anordnung der ersten und der zweiten Teilmenge von Öffnungen 339 an der ersten Multiaperturplatte 331 komplementär zu der Anordnung der ersten und der zweiten Teilmenge der zweiten Multiaperturplatte 335 ist, so dass die Bedingung erfüllt ist, dass ein jeder Teilchenstrahl genau eine Öffnung der beiden Multiaperturplatten 331 und 335 durchsetzt, an der Ablenkelemente 334 vorgesehen sind.

Jede der beiden Multiaperturplatten 331 und 335 umfasst Zuführungsleitungen 349, um den Ablenkelementen 334 einstellbare Erregungen zuzuführen, welche durch Versorgungsschaltungen 351 bereitgestellt werden. Nur wenige der Zuführungsleitungen 349 sind in den Figuren 3 und 4 dargestellt. Wenn die Ablenkelemente 334 Elektroden zur Erzeugung elektrischer Felder sind, so sind die Versorgungsschaltungen 351 Spannungsversorgungen. Wenn die Ablenkelemente 334 Spulen zur Erzeugung von Magnetfeldern sind, so sind die Versorgungsschaltungen 351 Stromversorgungen. Die Versorgungsschaltungen 351 werden von einer Steuerung 353 kontrolliert, um den Ablenkelementen 334 geeignete Erregungen zuzuführen. Es ist ersichtlich, dass die Zahl der notwendigen Zuleitungen 349 zum Erregen der Ablenkelemente 334 ein Vielfaches der Anzahl der Öffnungen 339 der ersten Teilmenge ist. Da jedoch die Anzahl der Öffnungen 339 der ersten Teilmengen der jeweiligen Multiaperturplatten 331 bzw. 335 geringer ist als die gesamte Zahl von Öffnungen 339 der jeweiligen Multiaperturplatte 331 bzw. 335, ist die Anzahl der Zuleitungen 349, welche an einer der beiden Multiaperturplatten 331 und 335 vorzusehen ist, im Vergleich zu der herkömmlichen Multiaperturplatte deutlich verringert, bei der sämtliche Öffnungen 339 ansteuerbare Ablenkelemente aufweisen.

Gemäß einem nicht in Figuren dargestellten Ausführungsbeispiel, welches eine Abwandlung der anhand der Figuren 2, 3 und 4 erläuterten Multiaperturplattenanordnung 305 ist, sind die Ablenkelemente 334 an sämtlichen Öffnungen 339 vorgesehen. Insbesondere sind Ablenkelemente 334 auch an den Öffnungen 339 der zweiten Teilmengen von Öffnungen 339 der mehreren Multiaperturplatten 331, 335 vorgesehen. Allerdings sind auch bei diesem abgewandelten Ausführungsbeispiel die Ablenkelemente 334 der zweiten Teilmenge von Öffnungen 339 nicht ansteuerbar, indem diese Ablenkelemente nicht durch Leitungsverbindungen 349 mit den Spannungsquellen bzw. Stromquellen 351 verbunden sind.

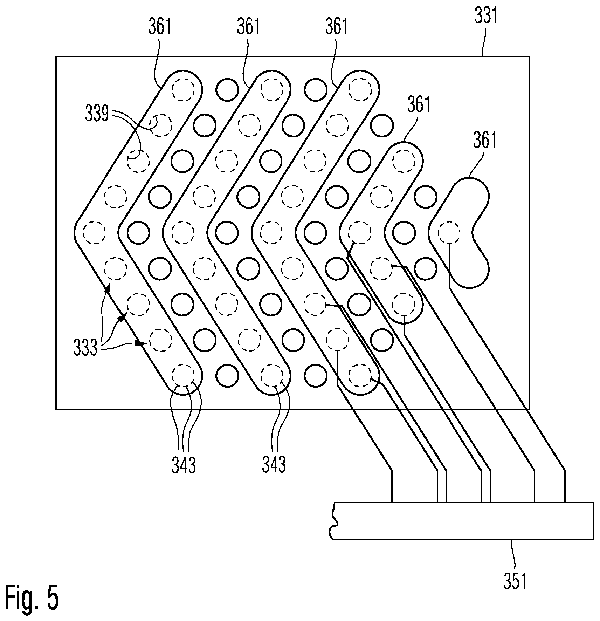

Figur 5 zeigt eine weitere Abwandlung der anhand der Figuren 2 bis 4 erläuterten Multiaperturplattenanordnung 305, die sich von der Multiaperturplattenanordnung der Figuren 2 bis 4 dadurch unterscheidet, wie die ersten und zweiten Teilmengen von Öffnungen an den Multiaperturplatten arrangiert sind. Figur 5 zeigt eine Draufsicht auf die erste Multiaperturplatte 331 mit Stigmatoren 333. Linien 361 in Figur 5 umranden jeweils eine Gruppe von Öffnungen 339 einer erste Teilmenge von Öffnungen 339, welche mit ansteuerbaren Ablenkelementen 334 versehen sind, während eine von den Linien 361 nicht umrandete zweite Teilmenge von Öffnungen 339 ansteuerbare Ablenkelemente nicht aufweist. Die durch die Linien umrandeten Gruppen sind als Pfeil- oder Bumerang-förmige Gestalten arrangiert. Die zugehörige zweite Multiaperturplatte 335, welche in den Figuren nicht dargestellt ist, weist eine Anordnung der Öffnungen 339 der ersten Teilmenge auf, welche zu der in Figur 5 gezeigten ersten Teilmenge komplementär ist.

In den anhand der Figuren 2 bis 5 beschriebenen Ausführungsformen sind an den Öffnungen jeweils acht Ablenkelemente vorgesehen, so dass die hierdurch gebildeten Multipol-Elemente als Stigmatoren betrieben werden können. Die erläuterten Prinzipien des Bereitstellens mehrerer Multiaperturplatten im Strahlengang hintereinander derart, dass jeder Teilchenstrahl genau eine Öffnung durchsetzt, welche wenigstens ein Ablenkelement aufweist, während die anderen von diesem Teilchenstrahl durchsetzten Öffnungen dieses wenigstens eine ansteuerbare Ablenkelement nicht aufweisen, sind auch auf Öffnungen anwendbar, welche ein Ablenkelement oder beispielsweise zwei oder vier in Umfangsrichtung um ein Zentrum verteilt angeordnete Ablenkelemente aufweisen.

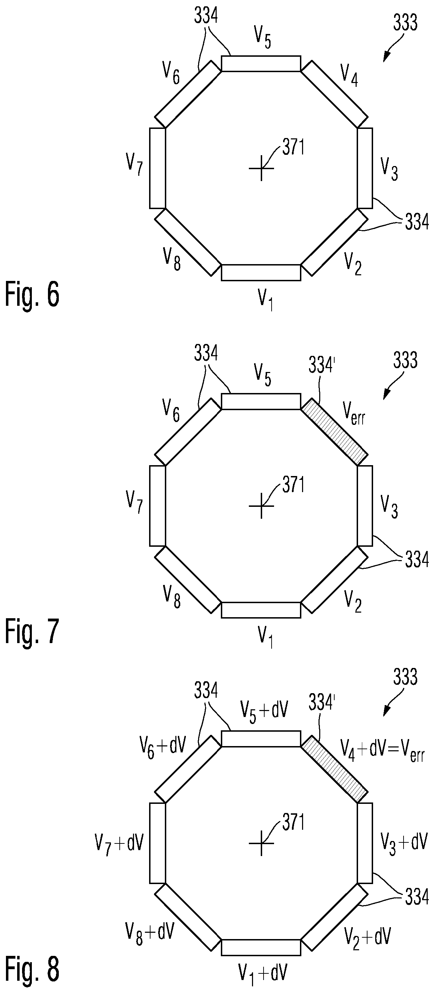

Figur 6 ist eine schematische Darstellung einer Draufsicht auf Ablenkelemente 334, welche in Umfangsrichtung um ein Zentrum 371 einer Öffnung einer Multiaperturplatte verteilt angeordnet sind. Die Ablenkelemente 334 bilden gemeinsam einen Stigmator 333 zur gezielten Kompensation eines Strahlastigmatismus eines die Öffnung durchsetzenden Teilchenstrahls. Hierzu werden die Ablenkelemente mit Erregungen erregt, welche so bestimmt werden, dass der Strahlastigmatismus möglichst weitgehend kompensiert wird. In dem dargestellten Beispiel sind die Ablenkelemente Elektroden, und die zur Kompensation bestimmten Erregungen sind elektrische Spannungen $V_1$, $V_2$, ... $V_8$, welche den einzelnen Elektroden 334 zugeführt werden.

Figur 7 ist eine der Figur 6 entsprechende Darstellung von Ablenkelementen 334, wobei allerdings ein mit 334' bezeichnetes Ablenkelement defekt ist. Beispielsweise ist die Zuführungsleitung zu diesem Ablenkelement 334' unterbrochen, oder das Ablenkelement 334' ist beispielsweise mit Masse verbunden oder dergleichen. Wenn den Ablenkelementen bzw. Elektroden 334 der Figur 7 die zuvor bestimmten Spannungen $V_1$, $V_2$, ... $V_8$ der Figur 6 zugeführt werden, so kann die defekte Elektrode 334' die Spannung $V_4$ nicht annehmen. Diese Elektrode nimmt vielmehr aufgrund des Defekts eine andere Spannung an, welche in Figur 7 mit $V_{err}$ bezeichnet ist. Es ist dann nicht möglich, eine zufriedenstellende Kompensation der Aberrationen des die Öffnung durchsetzenden Teilchenstrahls zu erreichen.

Figur 8 ist eine Darstellung der Ablenkelemente 334 der Figur 7 mit dem defekten Ablenkelement 334'. Allerdings werden die Ablenkelemente der Figur 8 mit gegenüber der Figur 7 bzw. Figur 6 abgewandelten Erregungen erregt. Die abgewandelten Erregungen werden durch Addieren von Korrektur-Erregungen zu den zuvor bestimmten Erregungen der Figur 6 bestimmt. Insbesondere werden den Elektroden 334 Spannungen $V_1 + dV$, $V_2 + dV$, ... $V_8 + dV$ zugeführt. Hier sind die Korrektur-Erregungen $dV$ für sämtliche Ablenkelemente gleich. Der Wert der Korrektur-Erregung $dV$ wird so bestimmt wird, dass folgende Relation erfüllt ist:

$$V_4 + dV = V_{err}.$$

Da die der defekten Elektrode 334' zuzuführende abgewandelte Spannung gleich der Spannung ist, die die defekte Elektrode aufgrund ihres Defekts annimmt, ist es möglich, die Ablenkelemente mit den abgewandelten Erregungen tatsächlich zu erregen. Ferner sind die Differenzen der Erregungen zwischen den einzelnen Ablenkelementen gleich den Differenzen zwischen den Erregungen der Ablenkelemente der intakten Ablenkelemente (vgl. Figur 6). Aufgrund der Gleichheit dieser Differenzen ist es möglich, dass insbesondere ein Strahlastigmatismus des den defekten Stigmator 333 durchsetzenden Teilchenstrahls genauso kompensierbar ist wie durch einen intakten Stigmator. Der Mittelwert der in Figur 8 an die Elektroden 334 des defekten Stigmators 333 angelegten abgewandelten Spannungen ist gegenüber dem Mittelwert der in Figur 6 an die Elektroden 334 des intakten Stigmators 333 angelegten bestimmten Spannungen um den Wert $dV$ erhöht. Deshalb üben die abgewandelten Erregungen auf den den defekten Stigmator 333 der Figur 8 durchsetzenden Strahl gegenüber dem den intakten Stigmator 333 der Figur 6 durchsetzenden Strahl zusätzlich eine Wirkung einer fokussierenden Linse aus. Diese zusätzliche Wirkung kann in manchen Situationen eine eventuell nachteilige Wirkung auf den Strahl sein, die in Kauf genommen werden kann, da die vorteilhafte Wirkung der Kompensation des Strahlastigmatismus trotz defektem Stigmator überwiegt.

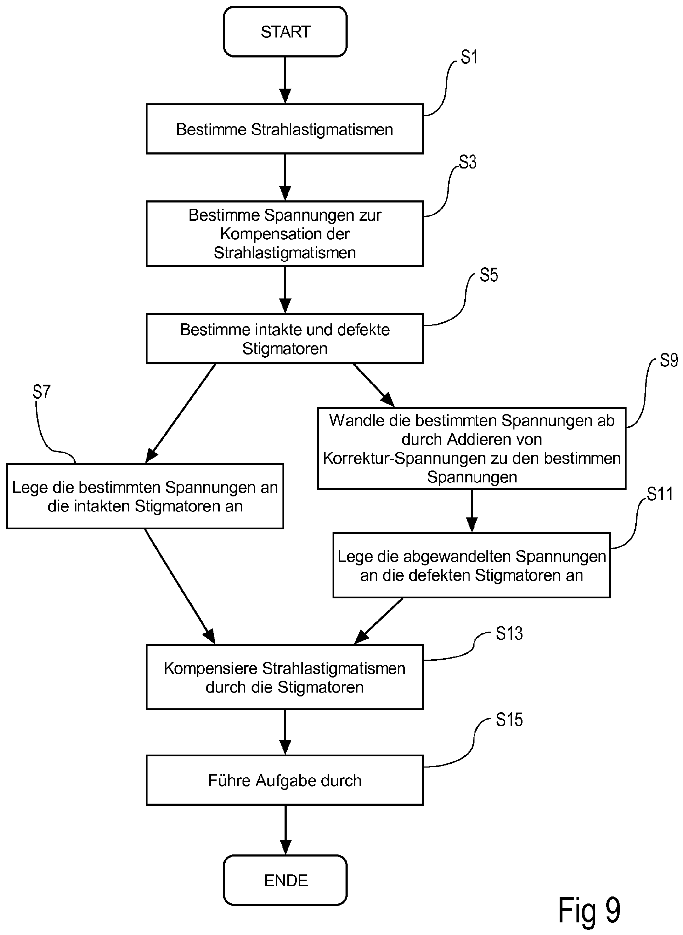

Ein Verfahren zum Betreiben eines Teilchenstrahlgeräts wird nachfolgend anhand des in Figur 9 gezeigten Flussdiagramms erläutert. Zu Beginn werden auftretende Strahlastigmatismen der Vielzahl von Teilchenstrahlen, mit denen das Vielstrahl-Teilchenstrahlsystem arbeitet, in einem Schritt S1 bestimmt. Diese Bestimmung kann anhand von Messungen erfolgen, welche mit dem Vielstrahl-Teilchenstrahlsystem vorgenommen werden. Es ist jedoch auch möglich, dass die Bestimmung anhand von Informationen durchgeführt wird, welche beispielsweise in einer Datenbank gespeichert sind.

In einem Schritt S3 werden Spannungen bestimmt, welche an Elektroden von Stigmatoren anzulegen sind, um die Strahlastigmatismen zu kompensieren.

In einem Schritt S5 wird bestimmt, welche Stigmatoren intakt und welche Stigmatoren defekt sind. Diese Bestimmung kann wiederum durch Messungen an dem Vielstrahl-Teilchenstrahlsystem durchgeführt werden. Ferner ist es möglich, dass die intakten und die defekten Stigmatoren bereits bekannt sind und diesbezügliche Informationen in einer Datenbank vorliegen, so dass die Bestimmungen in dem Schritt S5 durch Auswerten dieser Informationen erfolgen kann. Die Datenbank kann beispielsweise außerhalb des Vielstrahl-Teilchenstrahlsystems, in einer Steuerung des Vielstrahl-Teilchenstrahlsystems oder auch in einem Speicher vorgehalten werden, welcher an oder auf der Multiaperturplatte mit den Stigmatoren angeordnet ist.

Die in dem Schritt S3 bestimmten Spannungen werden in einem Schritt S7 an diejenigen Stigmatoren angelegt, welche in dem Schritt S5 als intakte Stigmatoren identifiziert wurden.

Für diejenigen Stigmatoren, welche in dem Schritt S5 als defekte Stigmatoren identifiziert worden, werden in einem Schritt S9 abgewandelte Spannungen bestimmt, indem zu dem in Schritt S3 bestimmten Spannungen Korrekturspannungen addiert werden.

Die in Schritt S9 bestimmten abgewandelten Spannungen werden in einem Schritt S11 an die defekten Stigmatoren angelegt.

Nach der Ausführung der Schritte S7 und S11 sind sowohl an die Elektroden der intakten Stigmatoren als auch die Elektroden der defekten Stigmatoren geeignete Spannungen angelegt, um die die Stigmatoren durchsetzenden Teilchenstrahlen in dem Schritt S13 geeignet zu beeinflussen. Daraufhin ist das Vielstrahl-Teilchenstrahlsystem einsatzbereit, so dass mit diesem in einem Schritt S15 Aufgaben durchgeführt werden können.

In den anhand der Figuren 6 bis 9 beschriebenen Ausführungsformen weisen die Multipol-Elemente acht Ablenkelemente auf und werden als Stigmatoren betrieben. Die erläuterten Prinzipien des Abwandelns der bestimmten Erregungen sind allerdings generell auf Multipol-Elemente anwendbar, welche wenigstens zwei in Umfangsrichtung um ein Zentrum verteilt angeordnete Ablenkelemente aufweisen.

Ferner sind in den anhand der Figuren 2 bis 9 beschriebenen Ausführungsformen die Ablenkelemente der Multipol-Elemente Elektroden, die durch das Anlegen von Spannungen erregt werden, um elektrische Felder zu erzeugen, die die Teilchen des das Multipol-Element durchsetzenden Teilchenstrahls ablenken. Das Abwandelns der bestimmten Erregungen ist jedoch auch auf Multipol-Elemente anwendbar, deren Ablenkelemente Spulen sind, die durch das Anlegen von Strömen erregt werden, um magnetische Felder zu erzeugen, die Teilchen des das Multipol-Element durchsetzenden Teilchenstrahls ablenken.

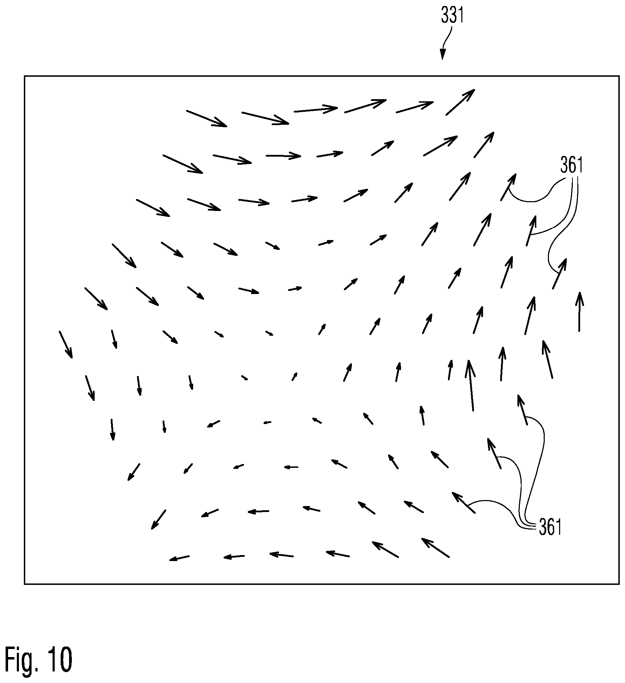

Figur 10 zeigt ein Feld aus 91 Vektoren 361. Ein jeder der Vektoren 361 repräsentiert eine Beeinflussung eines Teilchenstrahls, welcher eine Öffnung einer Multiaperturplatte 331 durchsetzt. Die Beeinflussung ist eine astigmatische Beeinflussung, und die Vektoren 361 repräsentieren durch ihre Länge die Stärke der astigmatischen Beeinflussung und durch ihre Richtung die Orientierung der astigmatischen Beeinflussung. In der Darstellung der Figur 10 sind die Füße der Vektoren am Zentrum einer jeweiligen Öffnung der Multiaperturplatte angeordnet. Es ist ersichtlich, dass die Öffnungen der erläuterten Multiaperturplatte 331 in einem hexagonalen Muster angeordnet sind.

Eine jede der Öffnungen der Multiaperturplatte 331 umfasst acht Ablenkelemente, welche in Umfangsrichtung um die Öffnung verteilt angeordnet sind. Den Ablenkelementen können einstellbare Erregungen zugeführt werden, um in der Öffnung ein elektrisches und/oder magnetisches Quadrupolfeld mit einer Stärke und einer Orientierung so bereitzustellen, dass eine hinsichtlich ihrer Stärke und Orientierung einstellbare astigmatische Beeinflussung des die Öffnung durchsetzenden Teilchenstrahls erfolgen kann.

Aus Figur 10 ist ersichtlich, dass die Vektoren 361 eine Vielzahl von verschiedenen Längen und verschiedenen Orientierungen aufweisen. Allerdings ist auch erkennbar, dass einander benachbarte Vektoren häufig Längen und Orientierungen aufweisen, die sich nicht stark voneinander unterscheiden. Aus diesem Grund werden bei der hier erläuterten Ausführungsform häufig den Ablenkelementen von einander benachbarten Öffnungen gleiche Erregungsmuster zugeführt, indem für die Ablenkelemente dieser einander benachbarten Öffnungen gemeinsame Zuleitungen eingesetzt werden.

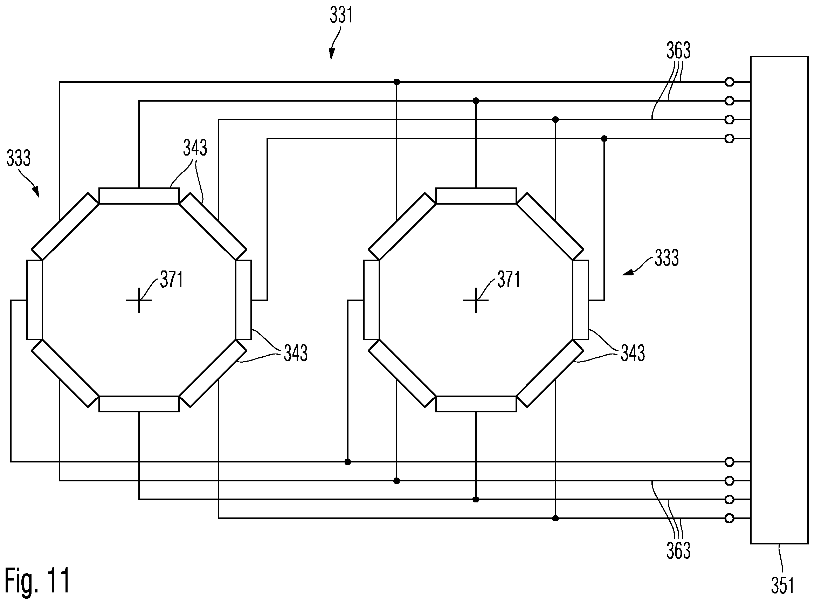

Eine Schaltung zur Zuführung von Erregungen an Ablenkelemente verschiedener Öffnungen über gemeinsame Zuleitungen ist in Figur 11 schematisch dargestellt. Figur 11 zeigt zwei Stigmatoren 333 mit jeweils acht Ablenkelementen 343, welche jeweils in Umfangsrichtung um ein Zentrum 371 einer Öffnung der Multiaperturplatte 331 angeordnet sind. Die Gesamtzahl der Ablenkelemente 343 der beiden Stigmatoren 333 beträgt somit sechzehn. Diesen sechzehn Ablenkelementen 343 werden von einem Spannungsversorgungssystem 351 Anregungen über lediglich acht Zuleitungen 363 zugeführt. Die Zuleitungen 363 können an der Oberfläche der Multiaperturplatte ausgebildet sein.

Bei der Zuführung von Erregungen durch gemeinsame Zuleitungen 363 ist es unvermeidlich, dass sich verschiedene Zuleitungen überkreuzen und dennoch voneinander isoliert sein müssen. Dies ist beispielsweise möglich, indem die Zuleitungen in zwei leitenden Schichten auf einem Substrat der Multiaperturplatte ausgebildet sind, wobei die leitenden Schichten voneinander isoliert sind und elektrisch leitende Verbindungen zwischen den beiden Schichten hergestellt werden können.

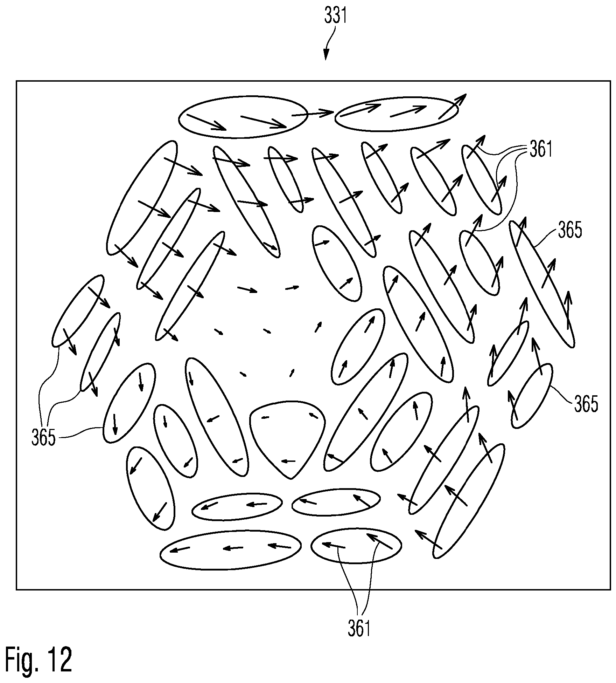

Figur 12 ist eine der Figur 10 entsprechende Darstellung des Feldes der Vektoren 361 und repräsentiert zusätzlich die Zuordnung von Öffnungen der Multiaperturplatte 331 zu Gruppen 365 von Öffnungen. Keine Öffnung gehört zwei verschiedenen Gruppen 365 an. Nicht alle Öffnungen müssen einer Gruppe 365 angehören. So gehören beispielsweise sieben Öffnungen, welche nahe dem Zentrum der Multiaperturplatte 331 angeordnet sind, keiner der Gruppen 365 an. Die Einteilung der Öffnungen in die Gruppen 365 ist so gewählt, dass die Vektoren 361 von Öffnungen einer gleichen Gruppe 365 sich jeweils hinsichtlich ihrer Länge und ihrer Orientierung nicht stark voneinander unterscheiden. Zwei bis drei Öffnungen sind jeweils in einer Gruppe 365 enthalten. Da sich die Vektoren 361 einer jeden Gruppe 365 hinsichtlich ihrer Länge und Orientierung nicht stark voneinander unterscheiden, ist vorgesehen, die Ablenkelemente von Öffnungen einer jeden Gruppe durch gemeinsame Zuleitungen mit Erregungen zu versorgen, wie dies in Figur 11 für die Ablenkelemente 343 einer Gruppe von zwei Öffnungen dargestellt ist. Es ist dann möglich, an einer jeden Öffnung einer gegebenen Gruppe 365 den die Öffnung durchsetzenden Teilchenstrahl zwar nicht exakt aber nahezu so zu beeinflussen, wie dies idealerweise gewünscht ist und durch das Feld aus Vektoren 361 der Figur 10 dargestellt ist.

Es hat sich gezeigt, dass die Einteilung der Öffnungen einer Multiaperturplatte in Gruppen, wie dies beispielhaft in Figur 12 dargestellt ist, in vielen Einsatzsituationen eines Vielstrahl-Teilchenstrahlsystems beibehalten werden kann. Die Einsatzsituationen können sich beispielsweise hinsichtlich der kinetischen Energie der die Öffnungen der Multiaperturplatte durchsetzenden Teilchenstrahlen oder der durch eine im Strahlengang hinter der Multiaperturplatte angeordneten Optik auf ein Objekt gerichteten Teilchenstrahlen unterscheiden. Für mehrere verschiedene kinetische Energien würde eine gleiche Einteilung der Öffnung der Multiaperturplatten in Gruppen, wie sie beispielhaft in Figur 12 gezeigt ist, zu einem guten Ergebnis der Beeinflussbarkeit der Teilchenstrahlen führen. Dies bedeutet, dass es sinnvoll sein kann, die Zuführung von Erregungen an die Ablenkelemente einer Multiaperturplatte durch gemeinsame Zuleitungen bei der Herstellung der Multiaperturplatte festzulegen, die Multiaperturplatte in ein Vielstrahl-Teilstrahlsystem zu integrieren, und dann das Vielstrahl-Teilchenstrahlsystem in einer Vielzahl von Einsatzsituationen zu verwenden.

**Patentansprüche**

1. Verfahren zum Betreiben eines Vielstrahl-Teilchenstrahlsystems (1), umfassend:

   Erzeugen einer Vielzahl von Teilchenstrahlen (3) derart, dass ein jeder Teilchenstrahl der Vielzahl von Teilchenstrahlen ein Multipol-Element (333) durchsetzt, wobei jedes Multipol-Element eine Mehrzahl von Ablenkelementen (334) aufweist, welche in Umfangsrichtung um ein Zentrum (371) des Multipol-Elements verteilt angeordnet sind, und wobei ein jedes der Multipol-Elemente entweder intakt oder defekt ist;
   Fokussieren der Teilchenstrahlen in einer vorbestimmten Ebene (10);
   Bestimmen von Erregungen für die Ablenkelemente der Multipol-Elemente, um die die Multipol-Elemente durchsetzenden Teilchenstrahlen zu beeinflussen, wobei die Erregungen für die Ablenkelemente eines jeden der Multipol-Elemente so bestimmt werden, dass die Fokussierung jedes der Teilchenstrahlen in der vorbestimmten Ebene einem vorbestimmten Kriterium genügt; und
   Erregen der Ablenkelemente der Multipol-Elemente, welche intakt sind, mit den bestimmten Erregungen;
   **gekennzeichnet durch** Abwandeln der bestimmten Erregungen für die Ablenkelemente wenigstens eines Multipol-Elements der Multipol-Elemente, welche defekt sind, und Erregen der Ablenkelemente des defekten Multipol-Elements mit den abgewandelten Erregungen; wobei das Abwandeln ein Addieren von Korrektur-Erregungen (dV) zu den bestimmten Erregungen umfasst, wobei die Korrektur-Erregungen für alle Ablenkelemente des defekten Multipol-Elements gleich sind.

2. Verfahren nach Anspruch 1,

   wobei das defekte Multipol-Element ein defektes Ablenkelement aufweist, dessen Erregung nicht einstellbar ist und eine durch den Defekt vorgegebene festgelegte Erregung ist, und wobei das Abwandeln ein Bestimmen der Korrektur-Erregungen derart umfasst, dass die Erregung, mit der das defekte Ablenkelement zu erregen ist, gleich der festgelegten Erregung ist.

3. Verfahren nach Anspruch 1 oder 2,

   wobei die Ablenkelemente Elektroden sind, wobei das Bestimmen der Erregungen ein Bestimmen von elektrischen Spannungen umfasst, und wobei das Erregen der Elektroden ein Anlegen der Spannungen an die Elektroden umfasst.

4. Verfahren nach einem der Ansprüche 1 bis 3, ferner umfassend Prüfen der Multipol-Elemente und Ermitteln der intakten Multipol-Elemente und der defekten Multipol-Elemente basierend auf der Prüfung.

5. Verfahren nach einem der Ansprüche 1 bis 3, ferner umfassend Auswerten eines bereitgestellten Datensatzes und Ermitteln der intakten Multipol-Elemente und der defekten Multipol-Elemente basierend auf der Auswertung des bereitgestellten Datensatzes.

6. Verfahren nach einem der Ansprüche 1 bis 5, ferner umfassend Bestimmen von Größen, welche eine gewünschte Beeinflussung des das Multipol-Element durchsetzenden Teilchenstrahls repräsentieren, für jedes der Multipol-Elemente.

7. Verfahren nach Anspruch 6, wobei das Bestimmen der Erregungen für die Ablenkelemente des Multipol-Elements derart erfolgt, dass, wenn die Ablenkelemente des Multipol-Elements mit den bestimmten Erregungen erregt werden, die Wirkung der Ablenkelemente auf den das Multipol-Element durchsetzenden Teilchenstrahl derart ist, dass die durch die Größen repräsentierte Beeinflussung des Teilchenstrahls erreicht wird.

**8.** Verfahren nach Anspruch 6 oder 7, wobei die Größen wenigstens einen zu kompensierenden Astigmatismus des Teilchenstrahls umfassen.

**9.** Verfahren nach einem der Ansprüche 1 bis 8. ferner umfassend Bestimmen wenigstens eines Ablenkelements, welches defekt ist, und Zuführen eines Hochspannungspulses an das defekte Ablenkelement, um den Defekt zu heilen.

**Claims**

**1.** Method for operating a multi-beam particle beam system (1), comprising:

generating a multiplicity of particle beams (3) in such a way that each particle beam of the multiplicity of particle beams passes through a multipole element (333), wherein each multipole element has a plurality of deflection elements (334), which are arranged distributed around a centre (371) of the multipole element in the circumferential direction, and wherein each of the multipole elements is either intact or defective;

focusing the particle beams in a predetermined plane (10);

determining excitations for the deflection elements of the multipole elements in order to influence the particle beams passing through the multipole elements, wherein the excitations for the deflection elements of each of the multipole elements are determined such that the focusing of each of the particle beams in the predetermined plane satisfies a predetermined criterion; and

exciting the deflection elements of the multipole elements which are intact with the determined excitations;

**characterized by** altering the determined excitations for the deflection elements at least of one multipole element of the multipole elements that are defective and exciting the deflection elements of the defective multipole element with the altered excitations;

wherein the altering comprises adding correction excitations (dV) to the determined excitations, wherein the correction excitations are the same for all deflection elements of the defective multipole element.

**2.** Method according to Claim 1,

wherein the defective multipole element has a defective deflection element, the excitation of which is not adjustable and is a defined excitation specified by the defect, and wherein the altering comprises determining the correction excitations in such a way that the excitation with which the defective deflection element is to be excited is equal to the defined excitation.

**3.** Method according to Claim 1 or 2,

wherein the deflection elements are electrodes, wherein determining the excitations comprises determining voltages, and wherein exciting the electrodes comprises applying the voltages to the electrodes.

**4.** Method according to any of Claims 1 to 3, further comprising checking the multipole elements and ascertaining the intact multipole elements and the defective multipole elements on the basis of the check.

**5.** Method according to any of Claims 1 to 3, further comprising evaluating a provided data set and ascertaining the intact multipole elements and the defective multipole elements on the basis of the evaluation of the provided data set.

**6.** Method according to any of Claims 1 to 5, further comprising determining variables which represent a desired influence on the particle beam passing through the multipole element for each of the multipole elements.

**7.** Method according to Claim 6, wherein the excitations for the deflection elements of the multipole element are determined in such a way that, when the deflection elements of the multipole element are excited with the determined excitations, the effect of the deflection elements on the particle beam passing through the multipole element is such that the influence on the particle beam represented by the variables is achieved.

**8.** Method according to Claim 6 or 7, wherein the variables comprise at least one astigmatism of the particle beam to be compensated.

**9.** Method according to any of Claims 1 to 8, further comprising determining at least one deflection element that is defective and supplying a high-voltage pulse to the defective deflection element to mend the defect.

## Revendications

1. Procédé permettant de faire fonctionner un système de faisceaux de particules à plusieurs faisceaux (1), comprenant :

   la production d'une pluralité de faisceaux de particules (3) de telle manière que chaque faisceau de particules de la pluralité de faisceaux de particules traverse un élément multipolaire (333), chaque élément multipolaire présentant une pluralité d'éléments de déviation (334) agencés en direction circonférentielle autour d'un centre (371) de l'élément multipolaire, et chacun des éléments multipolaires étant soit intact soit défectueux ;
   la focalisation des faisceaux de particules dans un plan prédéfini (10) ;
   la détermination d'excitations pour les éléments de déviation des éléments multipolaires afin d'influencer les faisceaux de particules traversant les éléments multipolaires, les excitations pour les éléments de déviation de chacun des éléments multipolaires étant déterminées de telle manière que la focalisation de chacun des faisceaux de particules dans le plan prédéfini satisfasse un critère prédéfini ; et
   l'excitation des éléments de déviation des éléments multipolaires qui sont intacts, au moyen des excitations déterminées ;
   **caractérisé par** la modification des excitations déterminées pour les éléments de déviation d'au moins un élément multipolaire parmi les éléments multipolaires qui sont défectueux, et l'excitation des éléments de déviation de l'élément multipolaire défectueux au moyen des excitations modifiées ;
   la modification comprenant l'ajout d'excitations de correction (dV) aux excitations déterminées, les excitations de correction étant identiques pour tous les éléments de déviation de l'élément multipolaire défectueux.

2. Procédé selon la revendication 1,

   dans lequel l'élément multipolaire défectueux présente un élément de déviation défectueux dont l'excitation n'est pas réglable et est une excitation fixe prédéfinie par le défaut, et
   dans lequel la modification comprend une détermination des excitations de correction de telle manière que l'excitation avec laquelle l'élément de déviation défectueux doit être excité soit égale à l'excitation fixe.

3. Procédé selon la revendication 1 ou 2,

   dans lequel les éléments de déviation sont des électrodes,
   dans lequel la détermination des excitations comprend la détermination de tensions électriques, et
   dans lequel l'excitation des électrodes comprend une application des tensions aux électrodes.

4. Procédé selon l'une quelconque des revendications 1 à 3, comprenant en outre
   le test des éléments multipolaires et la détermination des éléments multipolaires intacts et des éléments multipolaires défectueux sur la base du test.

5. Procédé selon l'une quelconque des revendications 1 à 3, comprenant en outre
   l'évaluation d'un ensemble de données fourni et la détermination des éléments multipolaires intacts et des éléments multipolaires défectueux sur la base de l'évaluation de l'ensemble de données fourni.

6. Procédé selon l'une quelconque des revendications 1 à 5, comprenant en outre
   la détermination de grandeurs qui représentent une influence souhaitée du faisceau de particules traversant l'élément multipolaire, pour chacun des éléments multipolaires.

7. Procédé selon la revendication 6,
   dans lequel la détermination des excitations pour les éléments de déviation de l'élément multipolaire est effectuée de telle manière que lorsque les éléments de déviation de l'élément multipolaire sont excités au moyen des excitations déterminées, l'effet des éléments de déviation sur le faisceau de particules traversant l'élément multipolaire est tel que l'influence du faisceau de particules représentée par les grandeurs est atteinte.

8. Procédé selon la revendication 6 ou 7,
   dans lequel les grandeurs comprennent au moins un astigmatisme à compenser du faisceau de particules.

9. Procédé selon l'une quelconque des revendications 1 à 8,
   comprenant en outre la détermination d'au moins un élément de déviation défectueux, et l'application d'une impulsion à haute tension à l'élément de déviation défectueux afin de remédier au défaut.

Fig. 1

Fig. 2

Fig. 3

Fig. 4

Fig. 5

Fig. 6

Fig. 7

Fig. 8

START

S1

Bestimme Strahlastigmatismen

S3

Bestimme Spannungen zur Kompensation der Strahlastigmatismen

S5

Bestimme intakte und defekte Stigmatoren

S7

Lege die bestimmten Spannungen an die intakten Stigmatoren an

S9

Wandle die bestimmten Spannungen ab durch Addieren von Korrektur-Spannungen zu den bestimmen Spannungen

S11

Lege die abgewandelten Spannungen an die defekten Stigmatoren an

S13

Kompensiere Strahlastigmatismen durch die Stigmatoren

S15

Führe Aufgabe durch

ENDE

Fig 9

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150348738 A1
- US 20150069260 A1
- WO 2005024881 A2
- WO 2007028595 A2
- WO 2007028596 A1
- WO 2007060017 A2
- DE 102013016113 A1
- DE 102013014976 A1
- DE 102014008083 A1